# EUROPEAN PATENT APPLICATION

(11) **EP 4 823 287 A1**
(43) Date of publication of application: **14.10.2026**
(21) Application number: 26165514.6
(22) Date of filing: 17.03.2026
(51) Int. Cl.: H10H 20/01, H10H 20/85

(54) **LED CARRIER ARRAY, LED CARRIER, AND MANUFACTURING METHOD THEREOF**

(30) Priority: 10.04.2025 CN 202510544227
(71) Applicant: Shenzhen Mega Precision Technology Co, Ltd., Shenzhen, Guangdong (CN)
(72) Inventor: Xiao, Biao, Shenzhen (CN)
(74) Representative: 2K Patent Partnerschaft mbB

(57) **Abstract**

An LED carrier array (100) comprises a conductive substrate (10) and an insulating frame (20), and defines a plurality of units. Each unit comprises a through slot (22) and a lead frame (11 or 12) of the conductive substrate (10), wherein the lead frame (11 or 12) is located in the through slot (22). A surface (21) of the insulating frame (20) is formed with a groove (24) connecting the through slot (22). The conductive substrate (10) has one or more connecting ribs (13) disposed in the groove (24) to connect the adjacent lead frames (11 or 12) located in the through slots (22). Before the LED carrier array (100) is cut into independent LED carriers (1), a sacrificial portion (131) of the connecting rib (13) is removed to leave a region (40) and separate the lead frames (11 or 12), and a cutting line (90) passes through the region (40).

## Description

### TECHNICAL FIELD

The present application relates to an LED carrier array, an LED carrier, and a manufacturing method thereof, and more particularly to an LED carrier array, an LED carrier, and a manufacturing method thereof that avoid cutting a conductive substrate.

### BACKGROUND

An LED (light emitting diode) carrier is an important component of an LED device, and its primary functions are to support an LED chip and provide electrical connections. The basic structure of the LED carrier includes a conductive substrate and an insulating frame covering the conductive substrate. The conductive substrate is used for electrical connection of the LED, and the insulating frame is used to isolate positive and negative electrodes of the conductive substrate and to support the LED. The LED carrier not only provides fixation and electrical conductivity for the LED, but also helps improve luminous efficiency and heat dissipation. Thus, it is widely applied in various LED devices.

A common manufacturing method for an LED carrier generally includes the following steps: providing a metal substrate to form electrodes; then forming an insulating frame covering the metal substrate; and finally cutting the insulating frame along a predetermined cutting line to form a plurality of independent carrier units. In addition, connecting ribs are usually provided between the electrodes on the metal substrate to facilitate subsequent electroplating, handling, and batch processing, thereby being advantageous for mass production of the LED carrier.

However, in the above process, the connecting ribs on the metal substrate must also be cut when the carrier units are finally separated, such that the cutting tool directly contacts, thereby abrading or scratching a bottom surface of the metal substrate, and increasing a risk of damaging the carrier units. In addition, since all of the electrodes are connected to each other via the connecting ribs, electrical testing cannot be individually performed on the conductive portions of each carrier before cutting, such that quality inspection can only be conducted after the entire process is completed, making it impossible to immediately detect defective products. Accordingly, although the existing manufacturing method of the LED carrier can achieve mass production, there remains room for improvement in enhancing manufacturing yield and quality control.

### BRIEF SUMMARY

In order to solve the above problems, the present application provides a method for manufacturing an LED carrier. The method comprises the following steps:
providing a semi-finished carrier, the semi-finished carrier comprising a conductive substrate (10) and an insulating frame (20) partially covering the conductive substrate (10), wherein the semi-finished carrier defines a plurality of units, each of the plurality of units comprises a through slot (22) formed in the insulating frame (20) and extending through the insulating frame (20) along a thickness direction and a lead frame (11 or 12) of the conductive substrate (10), the lead frame (11 or 12) is located in the through slot (22), a surface (21) of the insulating frame (20) is formed with a groove (24) laterally connecting the through slots (22) of the plurality of units, the conductive substrate (10) has one or more connecting ribs (13) disposed in the groove (24) to connect adjacent lead frames (11 or 12) located in the through slots (22), and the connecting rib (13) is integrally formed with the lead frame (11 or 12) and includes a sacrificial portion (131);
removing the sacrificial portion (131) of the connecting rib (13) to form a region (40), such that the lead frames (11 and 12) of the units are separated from each other; and
cutting the insulating frame (20) along a cutting line (90), wherein the cutting line (90) passes through the region (40), separating the insulating frame (20) of the plurality of units, and obtaining separated units from the semi-finished carrier.

The present application further provides an LED carrier array (100), comprising: a conductive substrate (10), comprising a plurality of lead frames (11, 12), and one or more connecting ribs (13) connecting the plurality of lead frames (11, 12), wherein the connecting rib (13) is integrally formed with the plurality of lead frames (11, 12) and includes a sacrificial portion (131); and an insulating frame (20) partially covering the conductive substrate (10), comprising a plurality of through slots (22) extending through the insulating frame (20) along a thickness direction, and one or more grooves (24) laterally connecting the plurality of through slots (22), wherein the plurality of lead frames (11, 12) are respectively disposed in the plurality of through slots (22), the connecting rib (13) is disposed in the groove (24), and a region (40) is formed on the groove (24) after the sacrificial portion (131) is removed; wherein the LED carrier array (100) defines a plurality of units which are adjacent to each other, and each of the plurality of units comprises one of the plurality of through slots (22) and one of the plurality of lead frames (11, 12).

The present application further provides an LED carrier (1), comprising a conductive substrate (10), comprising a lead frame (11 or 12), and one or more connecting ribs (13) connected to the lead frame (11 or 12), wherein the connecting rib (13) is integrally formed with the lead frame (11 or 12) and has a sacrificial portion (131); and an insulating frame (20) partially covering the lead frame (11 or 12), comprising a through slot (22) extending through the insulating frame (20) along a thickness direction, and one or more grooves (24) laterally connecting the through slot (22), wherein the lead frame (11 or 12) is disposed in the through slot (22), the connecting rib (13) is disposed in the groove (24), and a region (40) is formed on the groove (24) after the sacrificial portion (131) is removed.

### BRIEF DESCRIPTION OF FIGURES

FIG. 1 is a schematic perspective view of a lead frame;
FIG. 2 is a schematic perspective view of an insulating frame;
FIG. 3 is a schematic perspective view of an LED carrier array;
FIG. 4 is a schematic perspective view of the LED carrier after a sacrificial portion is removed;
FIG. 5 is a first schematic perspective view of the LED carrier;
FIG. 6 is a second schematic perspective view of the LED carrier;
FIG. 7 is a cross-sectional view taken along line A-A in FIG. 6;
FIG. 8 is a flowchart of a manufacturing method of the LED carrier according to one embodiment; and
FIG. 9 is a flowchart of a manufacturing method of the LED carrier according to another embodiment.

### DETAILED DESCRIPTION

In the present application, the terminology used in the description of various embodiments is for the purpose of describing particular examples only and is not intended to be limiting. Unless the context clearly indicates otherwise, or the number of elements is intentionally limited, the singular forms "a" and "the" as used herein also include plural forms. It will be further understood that the term "comprise(s)," when used in the present application, specifies the presence of stated features, elements, and/or components, but does not preclude the presence or addition of one or more other features, elements, components, and/or groups thereof. The indefinite and definite articles shall include both plural and singular forms unless the context clearly indicates otherwise.

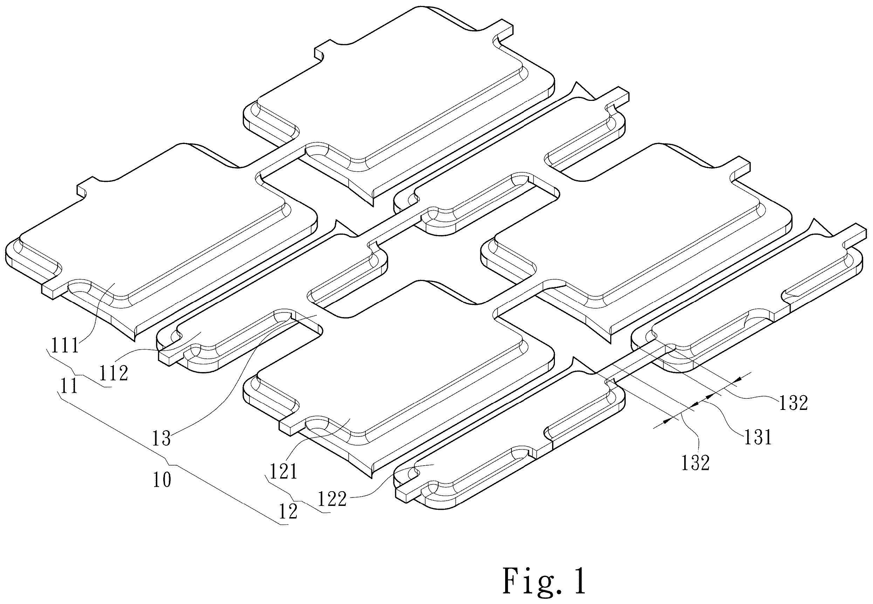

Referring to FIGS. 1 to 6, structures of an LED carrier array 100 and an LED carrier 1 of the present application are shown, wherein the LED carrier array 100 is cut to form a plurality of the LED carriers 1 that are independent from each other. Each LED carrier 1 includes a conductive substrate 10 and an insulating frame 20. The conductive substrate 10 is configured to support and electrically connect an LED chip (not shown). The insulating frame 20 partially covers the conductive substrate 10, and is configured to fix the conductive substrate 10 and to form a packaging space to protect the LED chip and wiring structure thereof.

Referring to FIG. 1, the conductive substrate 10 includes a plurality of lead frames 11, 12 and one or more connecting ribs 13, wherein the connecting rib 13 is integrally formed with the lead frames 11, 12 and connects the lead frames 11, 12. The connecting rib 13 includes a sacrificial portion 131 and two fixed portions 132 respectively located at two ends of the sacrificial portion 131, and the two fixed portions 132 are respectively connected to the lead frames 11, 12. The sacrificial portion 131 is defined as a portion that is removed before cutting the LED carrier array 100.

In one example, the conductive substrate 10 is a plate-shaped structure made of a metal material such as copper, stainless steel, or aluminum, and may be processed by metal processing methods such as etching, stamping, laser cutting, or electroforming to form the lead frames 11, 12 and the connecting rib 13.

In one example, each of the lead frames 11, 12 includes at least two electrodes spaced apart from each other, and the electrodes can be respectively connected to two leads of the LED. For example, as shown in FIG. 1, the lead frame 11 (a first lead frame) includes a first electrode 111 and a second electrode 112, and the first electrode 111 and the second electrode 112 are disposed opposite to each other and are spaced apart from each other. Similarly, the lead frame 12 (a second lead frame) includes a third electrode 121 and a fourth electrode 122, and the third electrode 121 and the fourth electrode 122 are disposed opposite to each other and are spaced apart from each other. In this example, the two fixed portions 132 of the connecting rib 13 are respectively connected to the second electrode 112 of the first lead frame 11 and the third electrode 121 of the second lead frame 12, so as to connect the first lead frame 11 and the second lead frame 12 to each other.

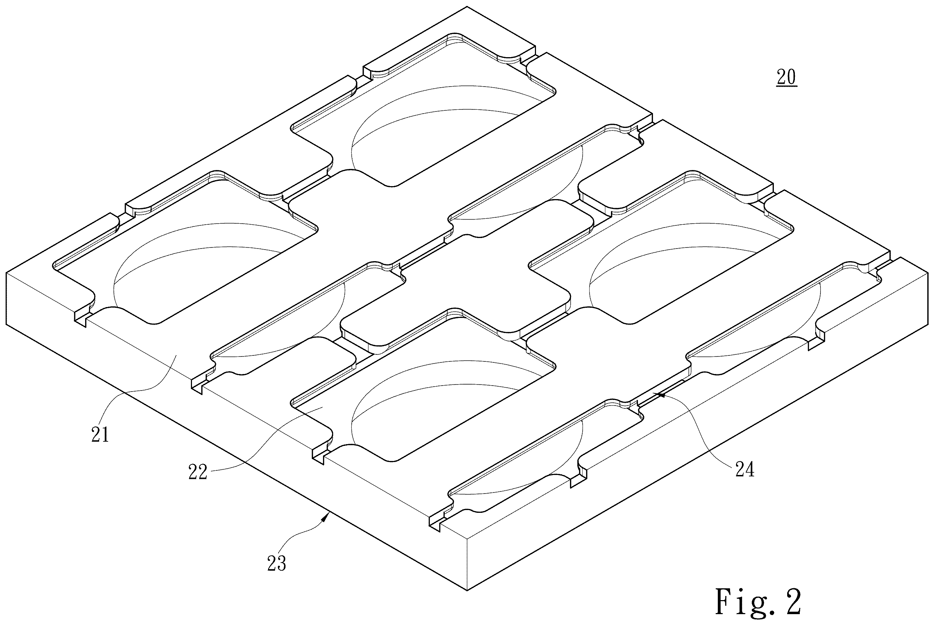

Referring to FIG. 2, a schematic perspective view of the insulating frame 20 is illustrated. The insulating frame 20 includes a first surface 21 and a second surface 23 opposite to the first surface 21, and the insulating frame 20 is formed with a plurality of through slots 22 and one or more grooves 24. Each through slot 22 extends through the first surface 21 and the second surface 23 along a thickness direction, and forms one or more openings on each of the first surface 21 and the second surface 23, wherein the openings are in communication with each other. Each groove 24 is formed in the first surface 21 and laterally connects the through slots 22, such that adjacent through slots 22 are in communication with each other through the groove 24.

In one example, the insulating frame 20 may be made of an insulating thermosetting plastic or thermoplastic, such as an epoxy molding compound (Epoxy Molding Compound, EMC) or a silicone molding compound (Silicone Molding Compound, SMC), but is not limited thereto.

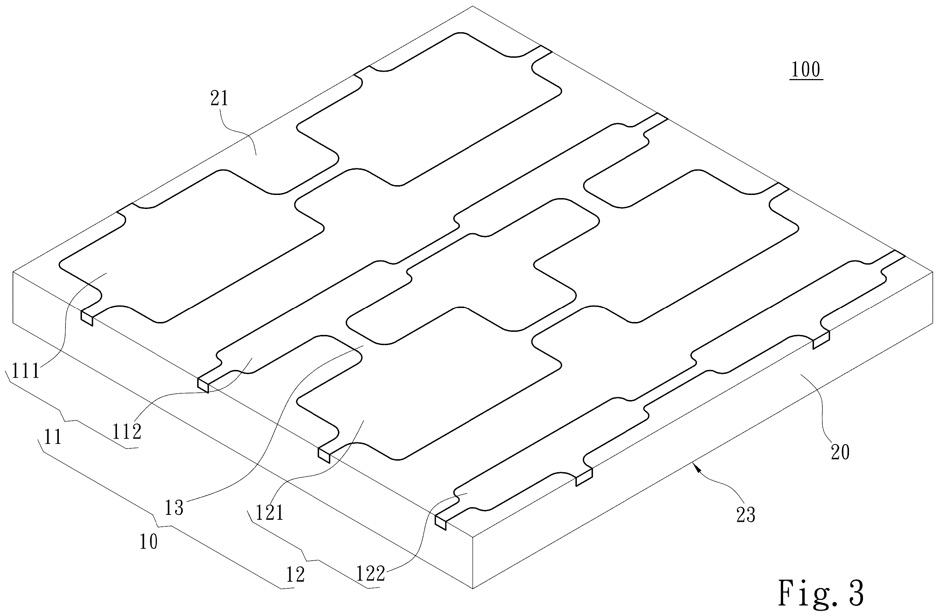

Referring to FIG. 3, a schematic perspective view of the LED carrier array 100 is illustrated. The insulating frame 20 covers an outer periphery of the conductive substrate 10, such that the conductive substrate 10 is located between the first surface 21 and the second surface 23. The lead frames 11, 12 are respectively located in the through slots 22, such that the openings on the first surface 21 and the second surface 23 are blocked and are not in communication with each other. The connecting rib 13 is located in the groove 24 and is exposed from the first surface 21.

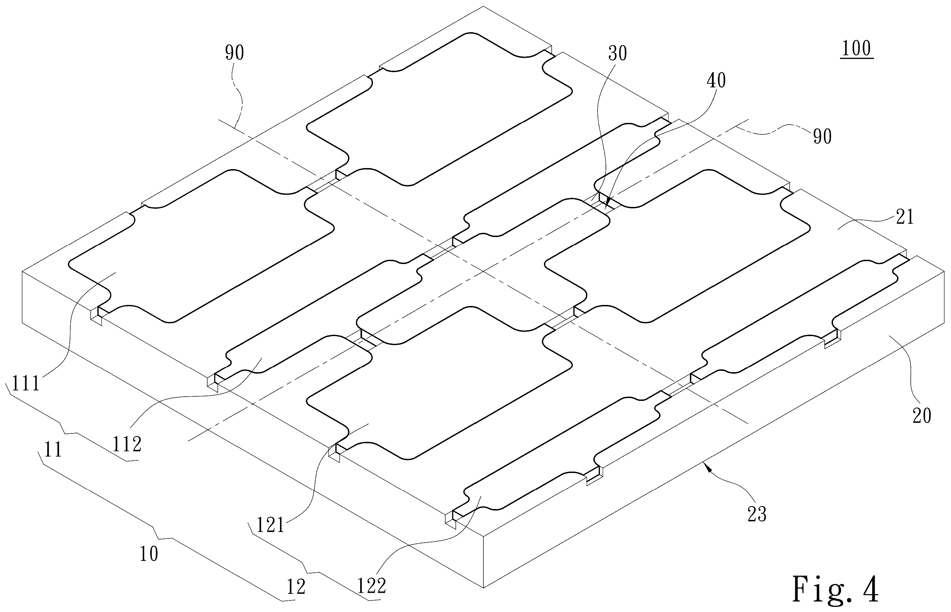

Referring further to FIG. 4, the LED carrier array 100 defines a plurality of units according to one or more cutting lines 90, and the units are adjacent to each other. Each unit corresponds to one LED carrier 1 after cutting. Each unit includes one through slot 22 and the lead frame 11 (or 12) located in the through slot 22. The connecting rib 13 and the groove 24 are connected between two adjacent units. Before the LED carrier array 100 is cut into the independent LED carriers 1, the sacrificial portion 131 of the connecting rib 13 is removed, and a region 40 is left at a corresponding position of the insulating frame 20 where the connecting rib 13 was originally located. The region 40 is a space without any metal material, thereby forming a gap between the lead frames 11, 12 to separate the lead frames 11, 12 from each other. After the sacrificial portion 131 of the connecting rib 13 is removed, a portion of the groove 24 is exposed in the region 40, and an end surface 30 at one end of each of the two fixed portions 132 is also exposed in the region 40. The LED carrier array 100 is cut along the cutting line 90, wherein the cutting line 90 passes through the region 40 and does not intersect any portion of the conductive substrate 10. That is, a cutting path of a cutting tool (not shown) only passes through a portion of the insulating frame 20 without the conductive substrate 10, and does not contact the conductive substrate 10.

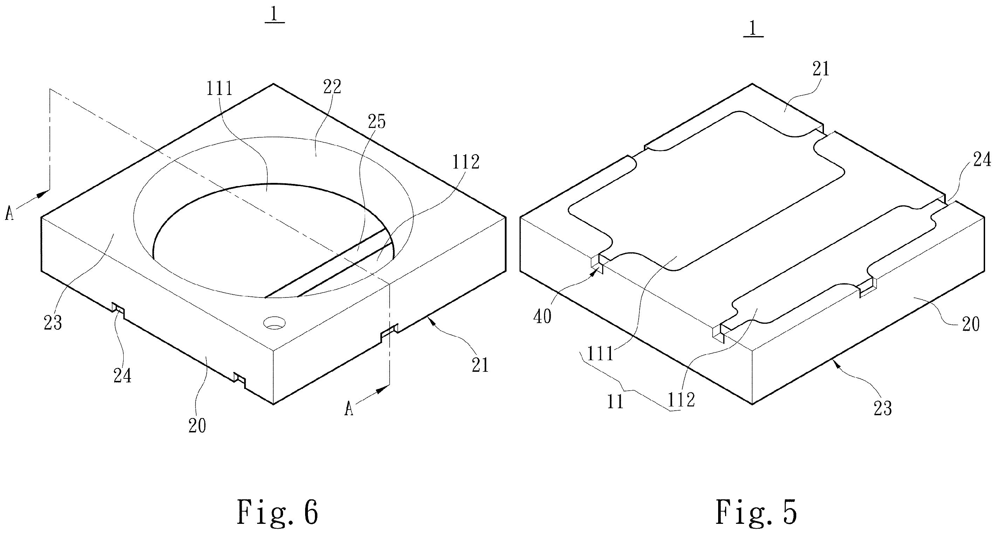

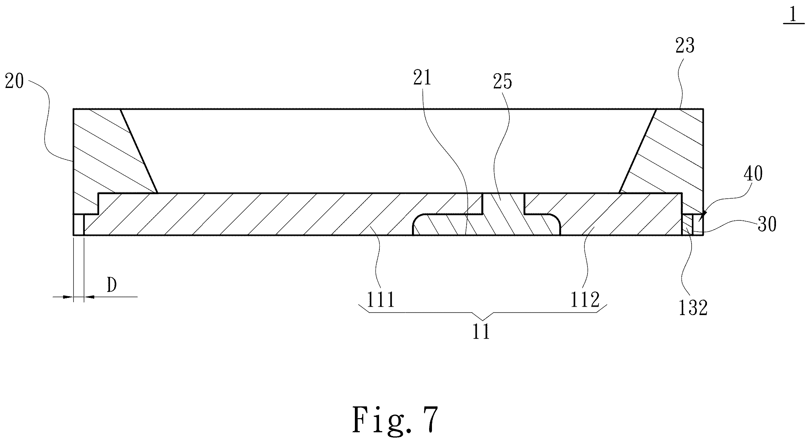

Please refer to FIGS. 5, 6, and 7. FIGS. 5 and 6 are schematic perspective views of the LED carrier 1 formed after the LED carrier array 100 is cut, as viewed from the first surface 21 and the second surface 23 of the LED carrier 1, respectively. FIG. 7 is a cross-sectional view of the LED carrier 1 taken along line A-A of FIG. 6. The LED carrier 1 includes the lead frame 11 and the insulating frame 20 partially covering the lead frame 11, and two surfaces of the lead frame 11 are respectively exposed from the first surface 21 and the second surface 23 of the insulating frame 20. The first surface 21 has the region 40 formed after the sacrificial portion 131 is removed. After the sacrificial portion 131 of the connecting rib 13 is removed, a portion of the groove 24 and the end surface 30 of the fixed portion 132 are exposed in the region 40. In one example, the end surface 30 is a planar surface rather than a curved, serrated, or stepped surface. In one example, an extending direction of the end surface 30 is parallel to a sidewall of the LED carrier 1. Since the sidewall of the LED carrier 1 is formed by cutting the LED carrier array 100 along the cutting line 90 (as shown in FIG. 4), the extending direction of the end surface 30 is also parallel to the cutting line 90. In one example, the end surface 30 is spaced apart from the sidewall of the LED carrier 1 by a predetermined distance D. That is, as viewed from the sidewall of the insulating frame 20, the conductive substrate 10 is recessed inwardly in the insulating frame 20. In one example, the predetermined distance D is between 0 and 0.2 mm.

Referring to FIGS. 6 and 7, in one example, the insulating frame 20 further includes a spacer 25 located between the first surface 21 and the second surface 23 and extending along the thickness direction. The spacer 25 divides the lead frame 11 into the first electrode 111 and the second electrode 112 that are electrically isolated from each other. In one embodiment, the spacer 25 extends from the first surface 21 toward the second surface 23, and the spacer 25 has the same thickness as the lead frames 11, 12.

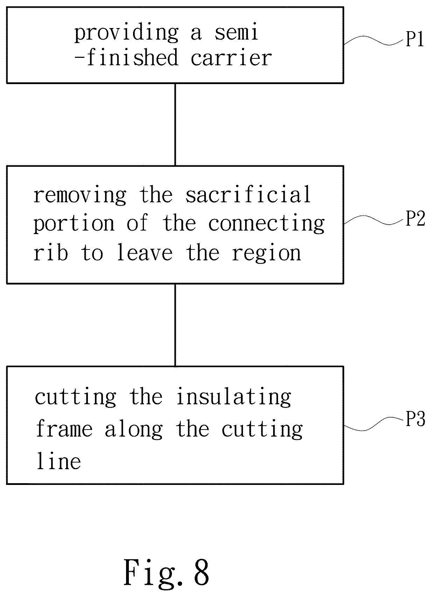

FIG. 8 is a flowchart of a manufacturing method of the LED carrier 1 according to one embodiment of the present application. The manufacturing method includes the following steps: step P1: providing a semi-finished carrier; step P2: removing the sacrificial portion of the connecting rib to leave the region; and step P3: cutting the insulating frame along the cutting line.

In step P1, the semi-finished carrier is the LED carrier array 100 shown in FIG. 3, which includes the conductive substrate 10 and the insulating frame 20, and the semi-finished carrier defines one or more units which are adjacent to each other. The conductive substrate 10 is made of a metal plate, and the lead frames 11, 12 and the connecting rib 13 connecting the lead frames 11, 12 are pre-formed on the metal plate. The connecting rib 13 is integrally formed with the lead frames 11, 12, and includes the sacrificial portion 131 and two fixed portions 132 respectively located at two ends of the sacrificial portion 131. The insulating frame 20 is formed at an outer periphery of the conductive substrate 10 to partially cover the conductive substrate 10. The insulating frame 20 forms the through slots 22 at positions corresponding to the lead frames 11, 12, and forms the groove 24 at a position corresponding to the connecting rib 13, wherein the groove 24 connects the through slots 22 of adjacent units. The insulating frame 20 may be made of an insulating thermosetting plastic or thermoplastic, such as an epoxy molding compound (EMC) or a silicone molding compound (SMC), but is not limited thereto.

In step P2, the sacrificial portion 131 of the connecting rib 13 is removed, thereby leaving the region 40 and exposing the corresponding portion of the groove 24. Removal of the sacrificial portion 131 may be performed by, but is not limited to, etching, laser processing, or mechanical cutting. As described above, since the lead frames 11, 12 are separated from each other after the connecting rib 13 is removed, electrical testing can be performed on each of the lead frames 11, 12 after this step, without waiting until the array is subsequently cut into independent LED carriers, thereby enabling real-time control of manufacturing quality.

In step P3, the insulating frame 20 of the LED carrier array 100 is cut along the cutting line 90, such that the separated lead frames 11, 12 respectively form independent LED carriers 1. The cutting line 90 passes through the region 40. Accordingly, during cutting, a cutting path of the cutting tool contacts only the insulating frame 20 and does not directly contact the conductive substrate 10, thereby preventing the cutting tool from directly damaging the lead frames 11, 12. After the LED carriers 1 are formed, the region 40 can be directly observed from the sidewall and the first surface 21 of each LED carrier 1, and the lead frame 11 (or 12) is laterally recessed inwardly from the sidewall. Accordingly, during subsequent surface mount technology (SMT) operations, solder paste can overflow from the region 40 in an appropriate amount, thereby facilitating inspection of solder quality.

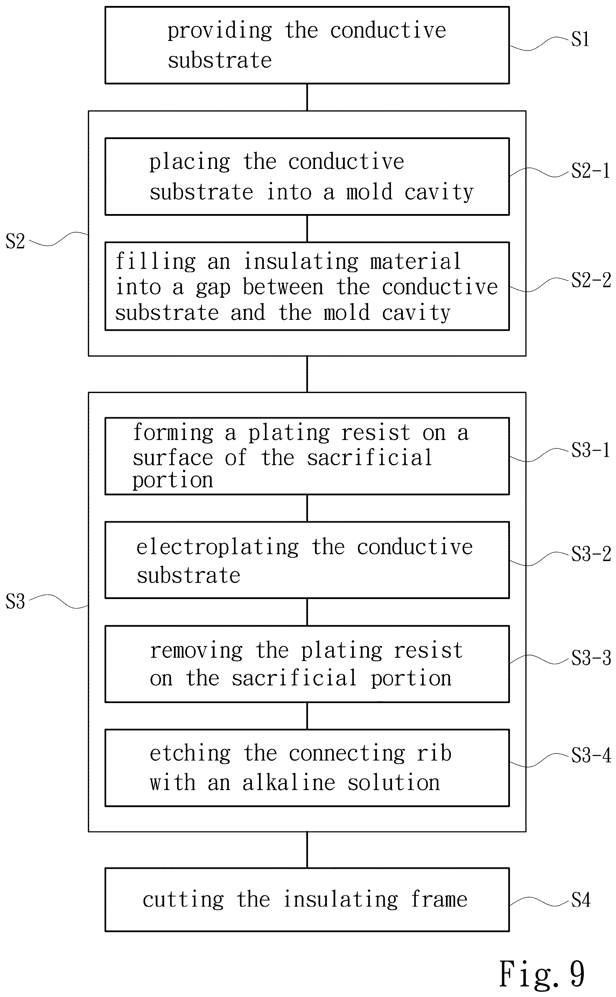

FIG. 9 is a flowchart of a manufacturing method according to another embodiment of the present application. The manufacturing method includes the following steps: step S1: providing the conductive substrate; step S2: forming the insulating frame covering the conductive substrate; step S3: removing the sacrificial portion of the connecting rib of the conductive substrate; and step S4: cutting the insulating frame.

In step S1, the conductive substrate 10 is provided. The conductive substrate 10 is made of a metal plate, and structures of a plurality of lead frames 11, 12 are pre-formed on the metal plate, wherein each of the lead frames 11, 12 is connected to another one of the lead frames 11, 12 by at least one connecting rib 13. The conductive substrate 10 may be manufactured by etching, stamping, laser cutting, or electroforming, but is not limited thereto.

In step S2, the insulating frame 20 is formed around an outer periphery of the conductive substrate 10. The insulating frame 20 covers and fixes the conductive substrate 10, such that each of the lead frames 11, 12 and the connecting rib 13 of the conductive substrate 10 is securely positioned in the insulating frame 20, thereby forming the LED carrier array 100 including a plurality of LED carriers 1. In one example, the insulating frame 20 may be made of an insulating thermosetting plastic or thermoplastic, such as an epoxy molding compound (EMC) or a silicone molding compound (SMC), but is not limited thereto.

In one example, an injection molding process is adopted in step S2 to form the insulating frame 20. In this example, step S2 includes the following sub-steps: step S2-1: placing the conductive substrate 10 into a mold cavity, and step S2-2: filling an insulating material into a gap between the conductive substrate and the mold cavity. After the insulating material is cured, the insulating frame 20 covering the conductive substrate 10 is formed.

In step S3, the sacrificial portion 131 of the connecting rib 13 is removed, thereby leaving the region 40 and exposing the corresponding portion of the groove 24. In one example, the sacrificial portion 131 of the connecting rib 13 may be removed by etching, laser processing, or mechanical cutting.

In one example, a selective electroplating and etching process is adopted in step S3 to remove the connecting rib 13. In this example, step S3 includes the following sub-steps: step S3-1: forming a plating resist on a surface of the sacrificial portion 131 of the connecting rib 13; step S3-2: electroplating the conductive substrate 10 to form an etch-resistant plated layer at least on the lead frames 11, 12 and the two fixed portions 132 of the connecting rib 13; step S3-3: removing the plating resist on the sacrificial portion 131; and step S3-4: etching the sacrificial portion 131 with an alkaline solution to remove the sacrificial portion 131, wherein the alkaline solution does not affect the lead frames 11, 12 and the two fixed portions 132, and only acts on the non-electroplated sacrificial portion 131. In one example, the plating resist is formed by ink printing. In one example, the plated layer is formed of gold, silver, or nickel/palladium/gold to improve surface conductivity of the lead frames 11, 12. In one example, the alkaline solution is a copper chloride solution.

Step S4 is the same as step P3. The insulating frame 20 of the LED carrier array 100 is cut along the cutting line 90, such that the separated lead frames 11, 12 respectively form independent LED carriers 1.

Compared with the conventional manufacturing method of an LED carrier, the present application further includes a step of removing the connecting rib on the conductive substrate that connects a plurality of adjacent electrodes before cutting the LED carrier array to form a plurality of independent LED carriers. Accordingly, the lead frames are separated and a region without any metal material is formed, such that the subsequent cutting operation passes only through the region without any metal material and does not cut the conductive substrate, thereby avoiding a problem that cutting the conductive substrate may cause poor adhesion between the insulating frame and the electrodes. In addition, after the connecting rib is removed, adjacent electrodes are not electrically connected, such that circuits of each electrode can be completely independent before cutting the LED carrier array, which is advantageous for performing electrical inspection in advance. Further, after the connecting rib is removed, the conductive substrate in the LED carrier array is no longer in an integrally connected state, thereby effectively improving flatness of the LED carrier array and reducing deformation risks, which is further advantageous for accuracy of a subsequent packaging process. After the LED carrier array is cut into the independent LED carriers, the groove at the original position of the connecting rib extends through a sidewall of the LED carrier, such that during subsequent surface mount technology operations, solder paste can overflow from the groove in an appropriate amount, thereby facilitating inspection of solder quality and improving convenience of process control.

## Claims

1. A method for manufacturing an LED carrier, comprising the following steps:
providing a semi-finished carrier, the semi-finished carrier comprising a conductive substrate (10) and an insulating frame (20) partially covering the conductive substrate (10), wherein the semi-finished carrier defines a plurality of units, each of the plurality of units comprises a through slot (22) formed in the insulating frame (20) and extending through the insulating frame (20) along a thickness direction and a lead frame (11 or 12) of the conductive substrate (10), the lead frame (11 or 12) is located in the through slot (22), a surface (21) of the insulating frame (20) is formed with a groove (24) laterally connecting the through slots (22) of the plurality of units, the conductive substrate (10) has one or more connecting ribs (13) disposed in the groove (24) to connect adjacent lead frames (11 or 12) located in the through slots (22), and the connecting rib (13) is integrally formed with the lead frame (11 or 12) and includes a sacrificial portion (131);
removing the sacrificial portion (131) of the connecting rib (13) to form a region (40), such that the lead frames (11 and 12) of the units are separated from each other; and
cutting the insulating frame (20) along a cutting line (90), wherein the cutting line (90) passes through the region (40), separating the insulating frame (20) of the plurality of units, and obtaining separated units from the semi-finished carrier.

2. The method of claim 1, wherein in the step of removing the sacrificial portion (131), the sacrificial portion (131) is etched using an alkaline solution.

3. The method of claim 1 or 2, wherein the step of removing the sacrificial portion (131) comprises the following sub-steps:
forming a plating resist on the sacrificial portion (131);
forming an etch-resistant plated layer on portions of the conductive substrate (10) other than the sacrificial portion (131);
removing the plating resist on the sacrificial portion (131); and
etching the sacrificial portion (131) using an alkaline solution.

4. The method of any of the claims 1 to 3, wherein the insulating frame (20) is formed by injection molding.

5. The method of any of the claims 1 to 4, wherein the connecting rib (13) further comprises two fixed portions (132), the two fixed portions (132) are respectively located between the sacrificial portion (131) and the lead frame (11 or 12), and wherein after the sacrificial portion (131) is removed, an end surface (30) of each of the two fixed portions (132) is exposed in the region (40), and the end surface (30) is a planar surface.

6. The method of claim 5, wherein an extending direction of the end surface (30) is parallel to the cutting line (90).

7. The method of claim 6, wherein the end surface (30) is spaced apart from the cutting line (90) by a predetermined distance (D).

8. An LED carrier array (100), comprising:
a conductive substrate (10), comprising a plurality of lead frames (11, 12), and one or more connecting ribs (13) connecting the plurality of lead frames (11, 12), wherein the connecting rib (13) is integrally formed with the plurality of lead frames (11, 12) and includes a sacrificial portion (131); and
an insulating frame (20) partially covering the conductive substrate (10), comprising a plurality of through slots (22) extending through the insulating frame (20) along a thickness direction, and one or more grooves (24) laterally connecting the plurality of through slots (22), wherein the plurality of lead frames (11, 12) are respectively disposed in the plurality of through slots (22), the connecting rib (13) is disposed in the groove (24), and a region (40) is formed on the groove (24) after the sacrificial portion (131) is removed;
wherein the LED carrier array (100) defines a plurality of units which are adjacent to each other, and each of the plurality of units comprises one of the plurality of through slots (22) and one of the plurality of lead frames (11, 12).

9. The LED carrier array (100) of claim 8, wherein the connecting rib (13) further comprises two fixed portions (132), the two fixed portions (132) are respectively located between the sacrificial portion (131) and the plurality of lead frames (11, 12), an end surface (30) of each of the two fixed portions (132) is exposed in the region (40), and the end surface (30) is a planar surface.

10. An LED carrier (1), comprising:
a conductive substrate (10), comprising a lead frame (11 or 12), and one or more connecting ribs (13) connected to the lead frame (11 or 12), wherein the connecting rib (13) is integrally formed with the lead frame (11 or 12) and has a sacrificial portion (131); and
an insulating frame (20) partially covering the lead frame (11 or 12), comprising a through slot (22) extending through the insulating frame (20) along a thickness direction, and one or more grooves (24) laterally connecting the through slot (22), wherein the lead frame (11 or 12) is disposed in the through slot (22), the connecting rib (13) is disposed in the groove (24), and a region (40) is formed on the groove (24) after the sacrificial portion (131) is removed.

11. The LED carrier (1) of claim 10, wherein the connecting rib (13) further comprises two fixed portions (132), the two fixed portions (132) are respectively located between the sacrificial portion (131) and the lead frame (11 or 12), an end surface (30) of each of the two fixed portions (132) is exposed in the region (40), and the end surface (30) is a planar surface.

12. The LED carrier (1) of claim 11, wherein an extending direction of the end surface (30) is parallel to a sidewall of the LED carrier (1).

13. The LED carrier (1) of claim 12, wherein the end surface (30) is spaced apart from the sidewall by a predetermined distance (D).
